# EUROPÄISCHE PATENTSCHRIFT

(11) **EP 2 854 157 B1**
(45) Veröffentlichungstag und Bekanntmachung des Hinweises auf die Patenterteilung: **09.01.2019**
(21) Anmeldenummer: 14199922.7
(22) Anmeldetag: 20.12.2010
(51) Int. Cl.: H01L 21/00, H01L 21/67, H01L 21/66, H01L 21/68, H01L 21/683

(54) **Aufnahmeeinrichtung zur Halterung von Wafern**
ACCOMMODATING DEVICE FOR RETAINING WAFERS
SYSTÈME DE LOGEMENT POUR LA RETENUE DE PLAQUETTES

(43) Veröffentlichungstag der Anmeldung: 01.04.2015
(62) Teilanmeldung aus: 10803232.7
(73) Patentinhaber: EV Group E. Thallner GmbH, 4782 St. Florian am Inn (AT)
(72) Erfinder: Wimplinger, Markus, 4910 Ried im Innkreis (AT); Wagenleitner, Thomas, 4971 Aurolzmünster (AT); Filbert, Alexander, 4782 St. Florian am Inn (AT)
(74) Vertreter: Schweiger, Johannes

(56) Entgegenhaltungen:
- WO-A1-2009/133682
- WO-A2-01/78108
- US-A- 4 475 223
- US-A- 5 094 536
- US-A1- 2006 237 421
- US-A1- 2008 188 036

## Beschreibung

Die Erfindung betrifft eine Aufnahmeeinrichtung zur Aufnahme und Halterung von Wafern gemäß Patentanspruch 1 sowie eine Vorrichtung und ein Verfahren zum Ausrichten eines ersten Wafers mit einem zweiten Wafer gemäß Patentansprüchen 8 und 9 unter Verwendung der Aufnahmeeinrichtung gemäß Patentanspruch 1.
Solche Aufnahmeeinrichtungen oder Probenhalter beziehungsweise Chucks gibt es in vielfältigen Ausführungen und entscheidend für die Aufnahmeeinrichtungen ist eine ebene Aufnahmefläche beziehungsweise Halterungsfläche, damit die immer kleiner werdenden Strukturen auf immer größeren Waferflächen über die gesamte Waferfläche korrekt ausgerichtet und kontaktiert werden können. Dies ist besonders wichtig, wenn ein sogenannter Pre-Bonding-Schritt, welcher die Wafer mittels einer trennbaren Verbindung miteinander verbindet, vor dem eigentlichen Bondvorgang durchgeführt wird. Besonders wichtig ist eine hohe Ausrichtungsgenauigkeit der Wafer zueinander, sobald für alle auf einem oder beiden Wafern angeordneten Strukturen eine Ausrichtungsgenauigkeit oder insbesondere Verzerrungswerte von < 2µm erreicht werden soll. In der Nähe von Ausrichtungsmarken gelingt dies bei bekannten Aufnahmeeinrichtungen und Vorrichtungen zur Ausrichtung, sogenannte Aligner, insbesondere Bondaligner, sehr gut. Mit zunehmendem Abstand von den Ausrichtungsmarken ist eine kontrollierte und perfekte Ausrichtung mit Ausrichtungsgenauigkeiten oder insbesondere Verzerrungswerten besser als 2µm, vorzugsweise besser als 1µm und noch bevorzugter besser als 0,25µm nicht erreichbar.
Eine Vorrichtung zur lokalen Kompensation von Verzerrungen ist aus der US5 094 536 A bekannt. Aus der WO 2009/133682 A1 ist ein indirektes Verfahren zur Ermittlung von Dehnungen über Positionsabweichungen von Wafermarkierungen bekannt.
Es ist die Aufgabe der vorliegenden Erfindung, gattungsgemäße Aufnahmeeinrichtungen derart zu verbessern, dass mit diesen eine genauere Ausrichtung erreicht werden kann.
Diese Aufgabe wird mit den Merkmalen der Ansprüche 1, 8 und 9 gelöst.
Vorteilhafte Weiterbildungen der Erfindung sind in den Unteransprüchen angegeben.
Die Erfindung basiert auf der Erkenntnis der Anmelderin gemäß den europäischen Patentanmeldungen EP 09012023 und EP 10 015 569, wobei mit erstgenannter eine Erfassung der gesamten Oberfläche, insbesondere der Positionen der Strukturen auf der Oberfläche eines jeden Wafers als Positionskarte des Wafers möglich ist. Die letztgenannte Erfindung betrifft eine Einrichtung zur Ermittlung von durch Dehnung und/oder Verzerrung eines ersten Wafers gegenüber einem zweiten Wafer beim Verbinden des ersten Wafers mit dem zweiten Wafer aufgetretenen lokalen Ausrichtungsfehlern mit:
- einer ersten Dehnungskarte von Dehnungswerten entlang einer ersten Kontaktfläche des ersten Wafers und/oder
- einer zweiten Dehnungskarte von Dehnungswerten entlang einer zweiten Kontaktfläche und
- Auswertungsmitteln zur Auswertung der ersten und/oder zweiten Dehnungskarten, durch welche die lokalen Ausrichtungsfehler ermittelbar sind.

Grundgedanke der vorliegenden Erfindung ist es dabei, eine Aufnahmeeinrichtung bestehend aus mehreren, voneinander unabhängigen aktiven Steuerelementen vorzusehen, mit welchen die Halterungsfläche der Aufnahmeeinrichtung, insbesondere in Form und/oder Temperatur, beeinflussbar ist. Dabei werden die aktiven Steuerelemente durch entsprechende Ansteuerung so verwendet, dass die mittels der Positionskarten und/oder Dehnungskarten bekannten lokalen Ausrichtungsfehler beziehungsweise lokalen Verzerrungen kompensiert beziehungsweise weitestgehend minimiert oder reduziert werden. Dabei werden nicht nur lokale Verzerrungen beseitigt, sondern eine sich aus den lokalen Verzerrungen insgesamt ergebende makroskopische Verzerrung oder Dehnung des Wafers in seinen Außenabmessungen wird gleichzeitig minimiert beziehungsweise korrigiert.

Somit ist es erfindungsgemäß insbesondere in Kombination mit den oben beschriebenen Erfindungen betreffend die Positionskarten, Dehnungskarten und/oder Spannungskarten sowie der dort offenbarten in-situ-Korrektur von Ausrichtungsfehlern beim Kontaktieren und Bonden der Wafer, möglich, durch aktive, insbesondere lokale Einwirkung auf Verzerrungen des Wafers ein noch besseres Ausrichtungsergebnis zu erreichen.

Gemäß einer vorteilhaften Ausführungsform der Erfindung ist vorgesehen, dass durch die Kompensationsmittel die Temperatur der Halterungsfläche lokal beeinflussbar ist. Eine lokale Temperaturerhöhung der Halterungsfläche führt zu einer lokalen Ausdehnung des auf der Halterungsfläche gehaltenen Wafers an dieser Position. Je höher der Temperaturgradient ist, desto mehr dehnt sich der Wafer an dieser Position aus. Basierend auf den Daten der Positionskarten und / oder Dehnungskarten, insbesondere der Vektorauswertung des Ausrichtungsfehlers, insbesondere für jede Position der Positionskarten und / oder Dehnungskarten, kann so gezielt auf lokale Verzerrungen des Wafers eingewirkt beziehungsweise diesen entgegengewirkt werden.

In diesem Zusammenhang ist als Vektorauswertung ein Vektorfeld mit Verzerrungsvektoren zu verstehen, das insbesondere mittels einer von zwei nachfolgend beschriebenen Erfindungsvarianten ermittelt wurde.

Die erste Variante bezieht sich auf Anwendungsfälle, in denen nur einer der beiden Wafer strukturiert ist. In diesem Fall ist es erfindungsgemäß vorgesehen, die Abweichung der Strukturen, insbesondere die Abweichung der geometrischen Form von der gewünschten Form zu erfassen. Von besonderem Interesse ist in diesem Fall die Abweichung der Form von Belichtungsfeldern, insbesondere Belichtungsfeldern eines Step & Repeat Belichtungsgerätes von der nominell erwarteten Form, die üblicherweise rechteckig ist. Diese Abweichungen, insbesondere das diese Abweichungen beschreibende Vektorfeld, kann basierend auf der Erfassung einer Positionskarte der einzelnen mit den Belichtungsfeldern korrespondierenden Ausrichtungsmarken gemäß EP 09012023 erfolgen. Alternativ kann dieses Vektorfeld auch basierend auf Spannungs- und/oder Dehnungskarten, die mittels EP 10 015 569.6 erfasst werden, ermittelt werden. Mit Vorteil kann dieses Vektorfeld aber erfindungsgemäß auch von jeder anderen, geeigneten Messeinrichtung ermittelt und eingelesen werden. Insbesondere eignen sich für diese Messung Step & Repeat Lithographiesysteme, die für die Erfassung dieser Daten mit einer speziellen Testmaske und/oder einer speziellen Testroutine betrieben werden.

Die zweite Variante bezieht sich auf Anwendungsfälle, in denen beide Wafer strukturiert sind. In diesem Fall ist es erfindungsgemäß vorgesehen, das Vektorfeld der Ausrichtungsabweichung insbesondere für alle Positionen der Positionskarten, insbesondere der ersten und zweiten Positionskarten gemäß EP 09012023 zu berechnen. Dieses Vektorfeld soll insbesondere für die, nach technologischen und/oder wirtschaftlichen Kriterien als ideal erachtete Ausrichtungsposition entsprechend der Ausführungen in EP 10 015 569.6 ermittelt werden.

In einer weiteren, vorteilhaften Ausführungsform der Erfindung ist vorgesehen, dass durch die Kompensationsmittel die Dehnung der Halterungsfläche, insbesondere durch Anordnung von, vorzugsweise einzeln ansteuerbaren, Piezoelementen an einer Rückseite der Halterungsfläche, lokal beeinflussbar ist. Durch Dehnung oder Schrumpfung, also negative Dehnung, der Halterungsfläche wird, insbesondere durch die von der Halterungsfläche auf den Wafer wirkende Haltekraft, auch der Wafer entsprechend verformt, insbesondere gedehnt oder geschrumpft, so dass auf diese Weise eine gezielte Beeinflussung des Wafers durch eine entsprechende Steuerungseinrichtung basierend auf den Werten der für diesen Wafer ermittelten Dehnungskarte möglich ist. Soweit durch die Kompensationsmittel die Form der Halterungsfläche, insbesondere durch, vorzugsweise mechanische, Einwirkung in einer Z-Richtung lokal beeinflussbar ist, besteht eine weitere Möglichkeit, Verzerrungen des Wafers an der Halterungsfläche entgegenzuwirken. Auch hier gilt, dass die Steuerung der Kompensationsmittel durch eine Steuereinrichtung erfolgt, die auf Grundlage der Werte der Positions- und/oder Dehnungskarten eine entsprechend gezielte, lokale Steuerung der Kompensationsmittel vornimmt.

Die Steuerungseinrichtung umfasst insbesondere eine Software zur Ausführung/Berechnung entsprechender Routinen.

Gemäß einer weiteren vorteilhaften Ausführungsform der Erfindung ist vorgesehen, dass die Halterungsfläche von einer Rückseite der Halterungsfläche durch die Kompensationsmittel lokal, insbesondere hydraulisch und/oder pneumatisch, mit Druck beaufschlagbar ist. Hierdurch kann ebenfalls auf die Form der Halterungsfläche Einfluss genommen werden, so dass sich die obengenannten Effekte ergeben. Die Steuerung erfolgt ebenfalls wieder durch die oben beschriebene Steuereinrichtung,

Mit Vorteil sind die Kompensationsmittel als eine Vielzahl aktiver Steuerelemente in der Aufnahmeeinrichtung, insbesondere in die Halterungsfläche integriert, vorzugsweise eingebettet, vorgesehen. Somit kann eine Aufnahme der Aufnahmeeinrichtung monolithisch ausgebildet sein, wie dies bei bekannten Aufnahmeeinrichtungen ebenfalls der Fall ist.

Dabei ist es von besonderem Vorteil, wenn jedes Steuerelement oder Gruppen von Steuerelementen gesondert ansteuerbar ist/sind. Entsprechend ist mit lokaler Ansteuerung gemeint, dass ein kleiner Ausschnitt insbesondere ein Ausschnitt kleiner als die Hälfte des Wafers, vorzugsweise kleiner als 1/4 des Wafers, vorzugsweise kleiner als 1/8 des Wafers, noch bevorzugter kleiner als 1/16 des Wafers, durch die Kompensationsmittel lokal ansteuerbar ist. Besonders vorteilhaft ist es, wenn die Kompensationsmittel auf jeden von einer eigenen Struktur belegten Bereich des Wafers mit mindestens einem Steuerelement einwirken können.

Die erfindungsgemäße Vorrichtung umfasst die vorbeschriebene Steuereinrichtung mit Vorteil in einer zentralen, für alle Steuerungsvorgänge zuständigen Steuereinheit. Erfindungsgemäß ist es jedoch denkbar, die Steuereinrichtung in der Aufnahmeeinrichtung, insbesondere als Modul einer Gesamtvorrichtung, vorzusehen.

Das erfindungsgemäße Verfahren kann dadurch noch weiter verbessert werden, indem nach der Ausrichtung eine, insbesondere nochmalige, Erfassung von Positions- und/oder Dehnungskarten des ersten und/oder zweiten Wafers vorgesehen ist. Damit kann erfindungsgemäß nach der erfolgten Ausrichtung eine Überprüfung des Ausrichtungserfolgs vorgesehen werden. Entsprechend ist es denkbar, eine Ausgliederung eines Waferpaares mit zu großen Ausrichtungsfehlern vorzunehmen, um diese beispielsweise erneut erfindungsgemäß auszurichten oder zu entsorgen. Gleichzeitig können die erfassten Daten zur Selbstkalibrierung der Vorrichtung, insbesondere mittels der Steuereinrichtung, verwendet werden.

Weitere Vorteile, Merkmale und Einzelheiten der Erfindung ergeben sich aus der nachfolgenden Beschreibung bevorzugter Ausführungsbeispiele sowie anhand der Zeichnungen, diese zeigen in:

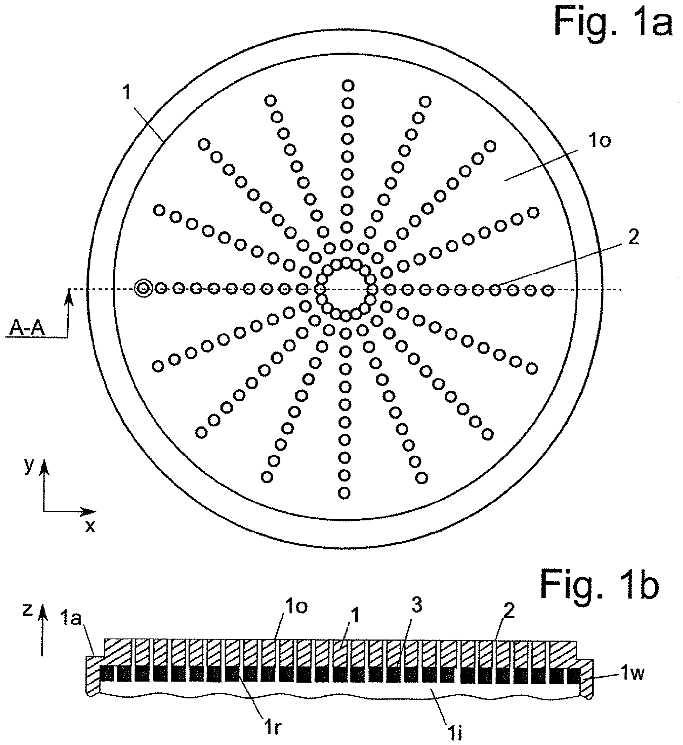

- Fig. 1a: eine Aufsicht auf eine Aufnahmeeinrichtung in einer ersten Ausführungsform,
- Fig. 1b: eine Querschnittsansicht der Aufnahmeeinrichtung gemäß Schnittlinie A-A aus Figur 1a,
- Fig. 2a: eine Aufsicht auf eine erfindungsgemäße Aufnahmeeinrichtung in einer zweiten Ausführungsform,
- Fig. 2b: eine Querschnittsansicht der Aufnahmeeinrichtung gemäß Schnittlinie B-B aus Figur 2a,
- Fig. 3a: eine Aufsicht auf eine Aufnahmeeinrichtung in einer dritten Ausführungsform,
- Fig. 3b: eine Querschnittsansicht der Aufnahmeeinrichtung gemäß Schnittlinie C-C aus Figur 3a,
- Fig. 4a: eine Aufsicht auf eine Aufnahmeeinrichtung in einer vierten Ausführungsform und
- Fig. 4b: eine Querschnittsansicht der Aufnahmeeinrichtung gemäß Schnittlinie D-D aus Figur 4a.
In den Figuren sind gleiche und gleichwirkende Bauteile/Merkmale mit den gleichen Bezugszeichen gekennzeichnet.
Alle vier Ausführungsformen zeigen eine monolithische Aufnahme 1, die als flache, vorzugsweise kreisringförmige, Platte mit einer plan ebenen Halterungsfläche 1o zur Aufnahme und Halterung von Wafern versehen ist. Am Außenumfang weist die Aufnahme einen ringförmigen Absatz 1a auf. Die Halterungsfläche 1o bildet eine Aufnahmeebene zur Aufnahme des Wafers, die sich in X- und Y-Richtung erstreckt. Hierzu senkrecht verläuft die Z-Richtung, in der die auf den Wafer wirkende Haltekraft gerichtet ist. Die Halterung des Wafers erfolgt durch Öffnungen 2, die in einer Vielzahl gleichförmig über die Halterungsfläche 10 verteilt angeordnet sind, um den Wafer an der Halterungsfläche 1o durch Beaufschlagung der Öffnungen 2 mit Unterdruck halten zu können. Je größer die Anzahl der Öffnungen 2 ist und je kleiner der Durchmesser der Öffnungen 2 ist, desto weniger führt der an den Öffnungen 2 anliegende Unterdruck zur Halterung des Wafers zu Verzerrungen des Wafers an den Öffnungen 2.

Der Unterdruck an den Öffnungen 2 wird über eine nicht dargestellte Vakuumeinrichtung angelegt, die einen rückseitig der Halterungsfläche 1o angeordneten Innenraum 1i mit Unterdruck beaufschlagt. Der Innenraum 1i ist weiterhin durch eine Umfangswand 1w der Aufnahme 1 begrenzt und gegenüber der Umgebung abgedichtet. Die Öffnungen 2 erstrecken sich von der Halterungsfläche 1o bis zum Innenraum 1i und sind somit gleichmäßig mit dem im Innenraum 1i vorherrschenden Unterdruck beaufschlagbar.

Der Innenraum 1i ist weiterhin durch eine gegenüberliegend zur Halterungsfläche 1o angeordnete Rückseite 1r und einen nicht dargestellten Boden des Innenraums 1i begrenzt, wobei die Rückseite 1r von den Öffnungen 2 durchsetzt ist.

Als aktive Steuerelemente sind an der Rückseite 1r eine Vielzahl von Heiz-/Kühlelementen, insbesondere ausschließlich Heizelemente 3, vorgesehen. Die Heizelemente 3 sind jeweils einzeln oder in Gruppen angesteuert, wobei die Steuerung durch eine nicht dargestellte Steuereinrichtung erfolgt. Beim Aufheizen eines der Heizelemente 3 heizt sich durch das sehr gut wärmeleitende Material, insbesondere Metall, der Aufnahme ein lokaler Abschnitt der Halterungsfläche 1o auf. Dies führt zu einer lokalen Ausdehnung eines auf der Halterungsfläche 1o liegenden Wafers in diesem Bereich. Somit kann bei entsprechend ausgerichtet auf der Aufnahmeeinrichtung aufgenommenem Wafer und bekannter Position von etwaigen Verzerrungen/Dehnungen gezielt durch Schalten einzelner oder mehrerer Heizelemente 3 eine Verformung des Wafers bewirkt werden, um lokale Verzerrrungen zu kompensieren. Hierdurch ergibt sich, insbesondere bei einer Vielzahl von lokalen Kompensationen, auch eine globale Kompensation von globalen Verzerrungen, insbesondere einer Änderung des Durchmessers des Wafers in X- und/oder Y-Richtung.

Ein besonderer Vorteil der Beeinflussung der Verzerrungen am Wafer mittels der Heiz- und / oder Kühlelemente liegt in der Möglichkeit, dies mit minimaler Verformung, insbesondere ohne Verformung der Halterungsfläche und/oder insbesondere ohne Verformung des Wafers in vertikaler Richtung beziehungsweise Z-Richtung, erreichen zu können. Als minimale Verformung in diesem Zusammenhang ist eine Verformung der Halterungsfläche und insbesondere des Wafers in vertikaler, das heißt senkrechter Richtung beziehungsweise in Z-Richtung im Verhältnis zur Auflagefläche von <5µm, mit Vorteil <2µm, bevorzugt <1µm und noch bevorzugter <0,5µm anzusehen. Dies ist insbesondere für das Herstellen von Pre-Bonding Verbindungen, beispielsweise für Pre-Bonds, die auf Van-der-Waals Verbindungen basieren, vorteilhaft. Aufgrund der Tatsache, dass hier die Halterungsfläche und insbesondere der Wafer eben gehalten werden kann, wird die bei derartigen Pre-Bonding Schritten übliche Bondwelle nicht in ihrer Ausbreitung durch Unebenheiten beeinflusst. Damit wird das Risiko, dass ungebondete Stellen (sogenannte Voids) verbleiben, stark reduziert. Für das Herstellen derartiger Pre-Bonding Verbindungen wird erfindungsgemäß eine Ebenheit der Halterungsfläche von <5µm, mit Vorteil <2µm, bevorzugt <1µm und noch bevorzugter <0,5µm über die gesamte Waferfläche angestrebt. Mit diesen Ebenheitswerten ist der Abstand zwischen dem höchsten und dem niedrigsten Punkt innerhalb jenes Teiles der Haltefläche, der mit dem Wafer in Kontakt ist, gemeint.

Die Heizelemente 3 sind mit Vorteil gleichmäßig unter der Halterungsfläche 1o verteilt. Mit Vorteil sind mehr als 10 Heizelemente 3, insbesondere mehr als 50 Heizelemente 3, vorzugsweise mehr als 100 Heizelemente 3, noch bevorzugter mehr als 500 Heizelemente 3, in der Aufnahmeeinrichtung vorgesehen. Diese Heizelemente bilden separat ansteuerbare Bereiche in der Halterungsfläche, die lokales Einwirken auf den Wafer ermöglichen. Mit Vorteil sind die einzelnen Bereiche der Halterungsfläche mit geeigneten Mitteln thermisch voneinander isoliert. Insbesondere sind die Bereiche in einer Form ausgebildet, die eine gleichmäßige und geschlossene Anordnung der einzelnen Segmente ermöglicht. Mit Vorteil eignet sich dafür die Ausbildung der Segmente als Dreiecke, Vierecke oder Sechsecke.

Als Heizelemente 3 sind insbesondere Peltierelemente geeignet.

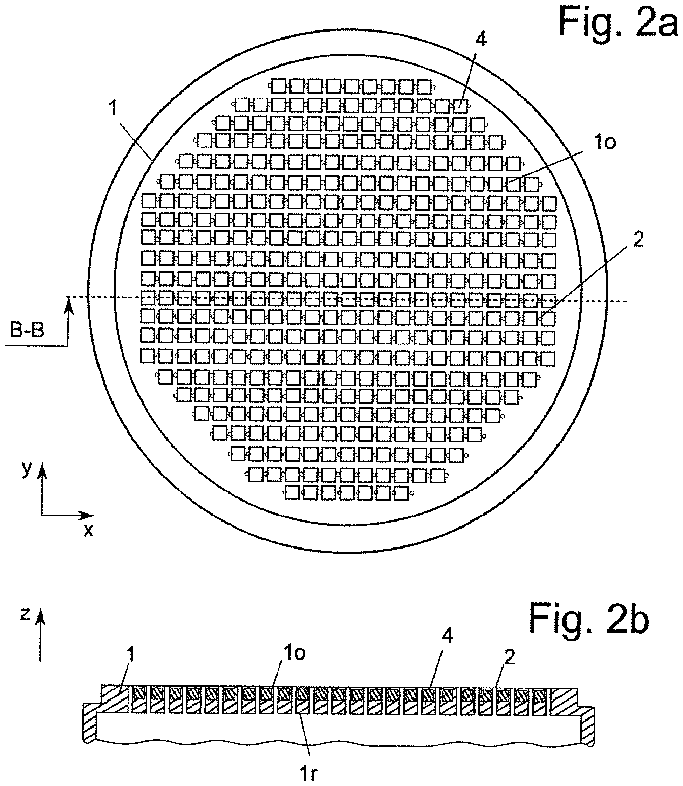

In der in den Figuren 2a und 2b gezeigten zweiten Ausführungsform sind keine Heizelemente 3 gezeigt und stattdessen oder in Kombination mit diesen sind Piezoelemente 4 an der Halterungsfläche 1o vorgesehen, vorzugsweise mit einem größeren Abstand zu der Rückseite 1r als zur Halterungsfläche 1o. Auf diese Weise ist ein gezieltes Einwirken auf die Halterungsfläche 1o möglich. Die Piezoelemente 4 können bei Aktivierung Dehnungen im Nanobis Mikrometerbereich bewirken.

Die Zahl der Piezoelemente 4 kann der obengenannten Zahl der Heizelemente 3 entsprechen, wobei eine Kombination der beiden Ausführungsformen erfindungsgemäß denkbar ist.

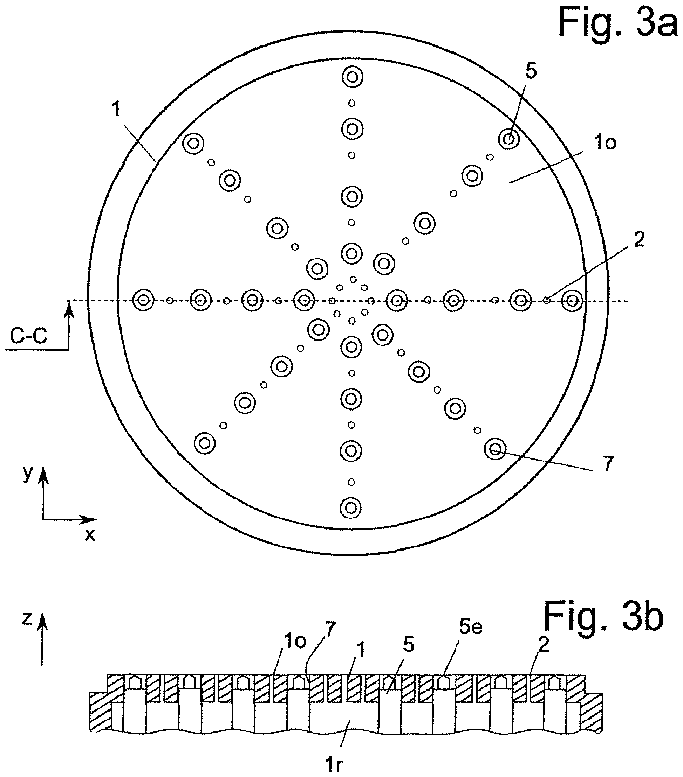

In der in den Figuren 3a und 3b gezeigten dritten Ausführungsform sind statt oder in Kombination mit den Heizelementen 3 und/oder den Piezoelementen 4 Stifte 5 vorgesehen, die an der Halterungsfläche 1o mit einem, insbesondere spitzen, Stiftende 5e enden. In der Ausgangslage der Stifte 5 ist das Stiftende 5e bündig mit der Halterungsfläche 1o. Soweit eine lokale Verzerrung eines Wafers im Bereich eines bestimmten Stiftes 5 als Information der Verzerrungskarte oder Dehnungskarte vorliegt, kann die Steuereinrichtung durch Ansteuerung einzelner oder mehrerer Stifte 5 lokal auf den Wafer einwirken, indem der Stift 5 beziehungsweise das Stiftende 5e in Z-Richtung in Richtung des Wafers bewegt wird. Das Stiftende 5e beaufschlägt damit den Wafer lokal mit einer Druckkraft, die für eine lokale Ausbeulung beziehungsweise Auslenkung des Wafers an dieser Stelle Sorge trägt. Der Stift 5 kann entweder als Ganzes in einer Führungsöffnung 7, die sich von der Halterungsfläche 1o bis zur Rückseite 1r erstreckt, gleitend geführt sein. Alternativ dazu ist nur das Stiftende 5e in dem Stift 5 bewegbar und der Stift 5 beziehungsweise der untere Abschnitt des Stifts gegenüber der Führungsöffnung 7 fixiert. Auf diese Weise kann eine besondere Abdichtung des Stifts 5 beziehungsweise der Stifte 5 gegenüber dem Innenraum 1r gewährleistet werden.

Die Anzahl der Stifte 5 entspricht der Anzahl der Piezoelemente 4 oder Heizelemente 3, wobei auch hier eine Kombination mit einer oder mehrerer der vorgenannten Ausführungsformen möglich ist.

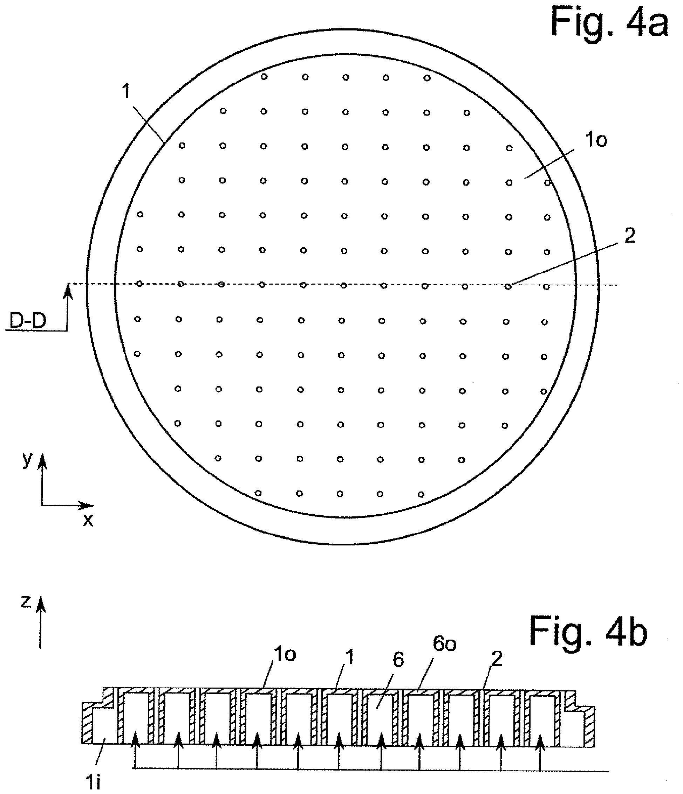

In der in Figur 4 gezeigten Ausführungsform weist die Aufnahme 1 eine Vielzahl von Druckkammern 6 auf, die mit ihrer in der Abbildung 4b gezeigten oberen Wand 6o die Halterungsfläche 1o bilden. Die Druckkammern 6 erstrecken sich durch den Innenraum 1i und sind gegenüber diesem abgedichtet. Jede der Druckkammern 6 oder Gruppen der Druckkammern 6 sind gesondert druckbeaufschlagbar, wobei die Steuerung durch die beschriebene Steuereinrichtung erfolgen kann. Bei Druckbeaufschlagung ist die Druckkammer 6 zumindest an ihrer oberen Wand 6o so ausgebildet, dass diese bei Druckbeaufschlagung nachgibt, also entweder dünner und/oder weicher als die anderen Begrenzungswände der Druckkammer 6 ausgebildet ist. Die Öffnungen 2 sind mit dem Innenraum 1i verbunden.

Erfindungsgemäß erfolgt eine lediglich minimale lokale Auslenkung der Halterungsfläche 1o durch die vorgenannten Kompensationsmittel 3, 4, 5, 6 um maximal 3µm, insbesondere maximal 1µm, vorzugsweise maximal 100 nm.

Um den lokalen Verzerrungen mit einer oder mehrerer der vorgenannten Ausführungsformen entgegenwirken zu können, ist es wie oben beschrieben notwendig, dass die Steuereinrichtung weiß, wo und in welchem Umfang beziehungsweise in welcher Richtung Verzerrungen im Wafer vorliegen. Erst dann ist ein gezieltes Einwirken beziehungsweise Entgegenwirken und Kompensieren der Verzerrungen möglich. Die Dehnungskarte eines jeden Wafers ergibt Aufschluss in Form von über den Wafer verteilten Dehnungsvektoren, die mit einer entsprechenden Messeinrichtung gemäß der EP 10 015 569.6 ermittelt worden sind. Entsprechende Steuerungsdaten können in der Steuerungseinheit, insbesondere empirisch ermittelt, hinterlegt sein, um für jeden Wafer eine individuelle Steuerung entsprechend der Dehnungskarte des Wafers an den durch die Positionskarte des Wafers vorgegebenen Positionen vornehmen zu können. Die Kompensation kann auf diese Weise automatisch während der Ausrichtung der Wafer durchgeführt werden.

Die aktiven Steuerelemente 3, 4, 5, 6 sind in den Figuren nicht maßstabsgetreu abgebildet und können auch verschiedene Größen oder Formen aufweisen.

### Bezugszeichenliste

- 1: Aufnahme
- 1a: ringförmiger Absatz
- 1i: Innenraum
- 1o: Halterungsfläche
- 1w: Umfangswand
- 2: Öffnungen
- 3: Heiz-/Kühlelemente
- 4: Piezoelemente
- 5: Stifte
- 5e: Stiftende
- 6: Druckkammern
- 6o: obere Wand
- 7: Führungsöffnung

## Patentansprüche

1. Aufnahmeeinrichtung zur Aufnahme und Halterung von Wafern mit folgenden Merkmalen:
- eine plan ebene, zur Verformung des Wafers dehnbar oder schrumpfbar ausgebildete Halterungsfläche (1o),
- Haltemittel zur Halterung des Wafers an der Halterungsfläche (1o) und
- Kompensationsmittel (3, 4, 5, 6) zur aktiven, lokal steuerbaren, zumindest teilweisen Kompensation von globalen Verzerrungen des Wafers,
**dadurch gekennzeichnet, dass**
die Kompensationsmittel (3, 4, 5, 6) als eine Vielzahl aktiver Steuerelemente (3, 4, 5, 6) in die Halterungsfläche (1o) integriert vorgesehen sind

2. Aufnahmeeinrichtung nach Anspruch 1, bei der durch die Kompensationsmittel (3, 4, 5, 6) die Temperatur der Halterungsfläche (1o) lokal beeinflussbar ist.

3. Aufnahmeeinrichtung nach einem der vorhergehenden Ansprüche, bei der durch die Kompensationsmittel (3, 4, 5, 6) die Dehnung der Halterungsfläche (1o), insbesondere durch Anordnung von vorzugsweise einzeln ansteuerbaren, Piezoelementen (4) an einer Rückseite (1r) der Halterungsfläche (1o), lokal beeinflussbar ist.

4. Aufnahmeeinrichtung nach einem der vorhergehenden Ansprüche, **dadurch gekennzeichnet, dass** durch die Kompensationsmittel (3, 4, 5, 6) die Form der Halterungsfläche (1o), insbesondere durch, vorzugsweise mechanische, Einwirkung in einer Z-Richtung, lokal beeinflussbar ist.

5. Aufnahmeeinrichtung nach einem der vorhergehenden Ansprüche, bei der die Halterungsfläche (1o) von einer Rückseite (1r) der Halterungsfläche (1o) durch die Kompensationsmittel (3, 4, 5, 6) lokal, insbesondere hydraulisch und/oder pneumatisch, mit Druck beaufschlagbar ist.

6. Aufnahmeeinrichtung nach einem der vorhergehenden Ansprüche, bei der die Kompensationsmittel (3, 4, 5, 6) in die Halterungsfläche (1o) eingebettet sind.

7. Aufnahmeeinrichtung nach Anspruch 6, bei der jedes Steuerelement (3, 4, 5, 6) oder Gruppen von Steuerelementen (3, 4, 5, 6) gesondert ansteuerbar ist/sind.

8. Vorrichtung zum Ausrichten eines ersten Wafers mit einem zweiten Wafer mit folgenden Merkmalen:
- eine Einrichtung zur Ermittlung von durch Dehnung und/oder Verzerrung des ersten Wafers gegenüber dem zweiten Wafer beim Verbinden des ersten Wafers mit dem zweiten Wafer aufgetretenen lokalen Ausrichtungsfehlern in Form eines Vektorfelds mit Verzerrungsvektoren,
- mindestens eine Aufnahmeeinrichtung nach einem der vorhergehenden Ansprüche zur Aufnahme wenigstens eines der Wafer und
- Ausrichtungsmittel zur Ausrichtung der Wafer unter Berücksichtigung des Vektorfelds sowie gleichzeitiger Kompensation durch die Kompensationsmittel.

9. Verfahren zum Ausrichten eines ersten Wafers mit einem zweiten Wafer mit folgenden Schritten, insbesondere folgendem Ablauf:
- Erfassung eines Vektorfelds mit Verzerrungsvektoren des ersten Wafers und/oder eines Vektorfelds mit Verzerrungsvektoren des zweiten Wafers und Auswertung des Vektorfelds durch Auswertungsmittel und Ermittlung der lokalen Ausrichtungsfehler,
- Aufnahme mindestens eines der Wafer auf einer Aufnahmeeinrichtung nach einem der Ansprüche 1 bis 7 und
- Ausrichtung der Wafer unter Berücksichtigung des Vektorfelds sowie gleichzeitiger Kompensation durch die Kompensationsmittel.

10. Verfahren nach Anspruch 9, bei dem nach der Ausrichtung eine, insbesondere nochmalige, Erfassung eines Vektorfelds des ersten und/oder zweiten Wafers vorgesehen ist.

## Claims

1. Receiving means for receiving and mounting of wafers with the following features:
- a flat leveled mounting surface (1o), which is stretchable or shrinkable for deformation of the wafer,
- mounting means for mounting of the wafer on the mounting surface (1o) and
- compensation means (3, 4, 5, 6) for active, locally controllable, at least partial compensation of global distortions of the wafer
**characterized in that**
the compensation means (3, 4, 5, 6) are integrated as a plurality of active control elements (3, 4, 5, 6) in the mounting surface (1o).

2. Receiving means as claimed in Claim 1, wherein the temperature of the mounting surface (1o) can be locally influenced by the compensation means (3, 4, 5, 6).

3. Receiving means as claimed in one of the preceding claims, wherein the strain of the mounting surface (1o) can be locally influenced by the compensation means (3, 4, 5, 6), especially by arrangement of piezoelements (4) which can preferably be individually activated on one back (1r) of the mounting surface (1o).

4. Receiving means as claimed in one of the preceding claims, wherein the shape of the mounting surface (1o) can be locally influenced by the compensation means (3, 4, 5, 6), especially by preferably mechanical action in one Z direction.

5. Receiving means as claimed in one of the preceding claims, wherein the mounting surface (1o) can be locally exposed to pressure from the back (1r) of the mounting surface (1o) by the compensation means (3, 4, 5, 6), especially hydraulically and/or pneumatically.

6. Receiving means as claimed in one of the preceding claims, wherein the compensation means (3, 4, 5, 6) are embedded into the mounting surface (1o).

7. Receiving means as claimed in Claim 6, wherein each control element (3, 4, 5, 6) or groups of control elements (3, 4, 5, 6) can be activated separately.

8. Device for alignment of a first wafer with a second wafer with the following features:
- a means for determining local alignment errors which have occurred due to strain and/or distortion of the first wafer relative to a second wafer when the first wafer is joined to the second wafer, with a first strain map of the first wafer and/or a second strain map of the second wafer and evaluation means for evaluation of the first and/or second strain maps,
- at least one receiving means as claimed in one of the preceding claims for receiving at least one of the wafers and
- alignment means for alignment of the wafer with consideration of the vector field and simultaneous compensation by the compensation means.

9. Method for alignment of a first wafer with a second wafer with the following steps, especially the following sequence:
- detecting a vector field with distortion vectors of the first wafer and/or a vector field with distortion vectors of the second wafer and evaluation of the vector fields by evaluation means and determination of the local alignment errors,
- receiving at least one of the wafers on a receiving means as claimed in one of Claims 1 to 7 and
- aligning the wafers with consideration of the vector field and simultaneous compensation by the compensation means.

10. Method as claimed in Claim 9, wherein after alignment, there is a detection, especially repeated, detection of position maps and/or strain maps of the first and/or second wafer.

## Revendications

1. Dispositif de réception pour la réception et le support de plaquettes avec les caractéristiques suivantes :
- une surface de support (1o) plane, conçue extensible ou contractable pour la déformation de la plaquette,
- des moyens de maintien pour le support de la plaquette sur la surface de support (1o), et
- des moyens de compensation (3, 4, 5, 6) pour la compensation au moins partielle, active et commandable localement, de distorsions de la plaquette,
**caractérisé en ce que**
- les moyens de compensation (3, 4, 5, 6) sont prévus de manière à être intégrés dans la surface de support (1o) sous la forme d'une pluralité d'éléments de commande (3, 4, 5, 6) actifs.

2. Dispositif de réception selon la revendication 1, dans lequel les moyens de compensation (3, 4, 5, 6) permettent d'influencer localement la température de la surface de support (1o).

3. Dispositif de réception selon l'une des revendications précédentes, dans lequel les moyens de compensation (3, 4, 5, 6) permettent d'influencer localement l'extension de la surface de support (1o), en particulier par l'agencement d'éléments piézoélectriques (4) de préférence aptes à être actionnés séparément sur une face arrière (1r) de la surface de support (1o),

4. Dispositif de réception selon l'une des revendications précédentes, **caractérisé en ce que** les moyens de compensation (3, 4, 5, 6) permettent d'influencer localement la forme de la surface de support (1o), en particulier une action de préférence mécanique dans une direction Z.

5. Dispositif de réception selon l'une des revendications précédentes, dans lequel la surface de support (1o) peut être soumise à une pression localement, en particulier de façon hydraulique et/ou pneumatique, depuis une face arrière (1r) de la surface de support (1o) par les moyens de compensation (3, 4, 5, 6)

6. Dispositif de réception selon l'une des revendications précédentes, dans lequel les moyens de compensation (3, 4, 5, 6) sont enrobés dans la surface de support (1o).

7. Dispositif de réception selon la revendication 6, dans lequel chaque élément de commande (3, 4, 5, 6) ou des groupes d'éléments de commande (3, 4, 5, 6) peut/peuvent être commandé(s) séparément.

8. Système pour l'orientation d'une première plaquette avec une deuxième plaquette, comprenant les caractéristiques suivantes :
- un dispositif pour la détermination d'erreurs d'orientation locales causées par l'extension et/ou la distorsion de la première plaquette par rapport à la deuxième plaquette lors de l'assemblage de la première plaquette avec la deuxième plaquette, sous la forme d'un champ vectoriel avec des vecteurs de distorsion,
- au moins un dispositif de réception selon l'une des revendications précédentes, pour la réception d'au moins une plaquette, et
- des moyens d'orientation pour l'orientation de la plaquette en tenant compte du champ vectoriel et avec une compensation simultanée par les moyens de compensation.

9. Procédé pour l'orientation d'une première plaquette avec une deuxième plaquette, comprenant les étapes suivantes, en particulier dans l'ordre suivant :
- détection d'un champ vectoriel avec des vecteurs de distorsion de la première plaquette et/ou d'un champ vectoriel avec des vecteurs de distorsion de la deuxième plaquette, et évaluation du champ vectoriel par des moyens d'évaluation, et détermination des erreurs d'orientation locales,
- réception d'au moins une plaquette sur un dispositif de réception selon l'une des revendications 1 à 7, et
- orientation de la plaquette en tenant compte du champ vectoriel, et compensation simultanée par les moyens de compensation.

10. Procédé selon la revendication 9, dans lequel, après l'orientation, il est prévu une détection, en particulier nouvelle, d'un champ vectoriel de la première et/ou de la deuxième plaquette.
